# EUROPEAN PATENT APPLICATION

(11) **EP 3 675 174 A1**
(43) Date of publication of application: **01.07.2020**
(21) Application number: 18847997.6
(22) Date of filing: 12.06.2018
(51) Int. Cl.: H01L 27/32

(54) **DISPLAY SUBSTRATE AND DISPLAY APPARATUS**

(30) Priority: 24.08.2017 CN 201721072741 U
(71) Applicant: BOE Technology Group Co., Ltd., Beijing 100015 (CN)
(72) Inventor: CHENG, Hongfei, Beijing 100176 (CN)
(74) Representative: Brötz, Helmut
(86) International application number: PCT/CN2018/090839
(87) International publication number: WO 2019/037520

(57) **Abstract**

A display substrate (DP) and a display apparatus (DA). The display substrate (DP) comprises a base substrate (1); and a pixel defining layer (6), which is provided with a hollow part (61) and which is located above the base substrate (1). The hollow part (61) is enclosedly formed by means of side walls (SW) of the pixel defining layer (6) and a lower portion thereof exposes a part of a conductive surface (51). In the cross-sectional view of the display substrate (DP), the side walls (SW) are shown as two side edges (c) that are located on two opposite sides of the hollow structure (61) respectively; each side edge (c) at least comprises a first straight line section (c; c1) that directly contacts the conductive surface, a first included angle between the first straight line section (c; c2) and the conductive surface (51) being greater than 20° and less than 35°. As such, uniformity in the deposited thickness of an organic light-emitting layer may be increased, further improving the display quality of the display substrate.

## Description

The present application claims priority of Chinese Patent Application No. 201721072741.6 filed on August 24, 2017, the disclosure of which is incorporated herein by reference in its entirety as part of the present application.

### TECHNICAL FIELD

Embodiments of the present disclosure relate to a display substrate and a display device.

### BACKGROUND

An Active Matrix Organic Light-Emitting Diode (AMOLED) display has a wide market application, due to advantages such as self-illumination, fast response, wide viewing angle, high brightness, brilliant colors, lightness and thinness, as compared with a traditional liquid crystal display. One of core structures of the AMOLED display is an OLED element, in which a light emitting region of a pixel is defined with a pixel defining layer having a hollow portion.

### SUMMARY

According to embodiments of the disclosure, a display substrate is provided. The display substrate comprises: a base substrate; and a pixel defining layer having a hollow portion and located above the base substrate. The hollow portion is enclosed by sidewalls of the pixel defining layer, and exposes a portion of a conductive surface at a bottom of the hollow portion; in a cross-sectional view of the display substrate, the sidewalls are respectively indicated by two side edges located on two opposite sides of the hollow portion, each of the side edges at least includes a first straight line segment in direct contact with the conductive surface, and a first included angle between the first straight line segment and the conductive surface is greater than 20° and less than 35°.

In one example, the first included angle is further greater than 23° and less than 30°.

In one example, the hollow portion is symmetrical about a symmetry axis.

In one example, in the cross-sectional view of the display substrate, the first straight line segment meets a surface of the pixel defining layer facing away from the base substrate.

In one example, in the cross-sectional view of the display substrate, each of the side edges further includes a second straight line segment that meets a surface of the pixel defining layer facing away from the base substrate and a third straight line segment connecting the first straight line segment and the second straight line segment.

In one example, the second straight line segment is parallel to the first straight line segment, and the third straight line segment is parallel to the conductive surface.

In one example, the display substrate has a light emitting region, and an orthogonal projection of the portion of the conductive surface exposed by the hollow portion of the pixel defining layer on the base substrate completely coincides with an orthogonal projection of the light emitting region on the base substrate.

In one example, the pixel defining layer has a thickness of 1.0 µm to 3.0 µm.

In one example, the display substrate further comprises: a driving unit provided on the base substrate; a passivation layer covering the driving unit; a first electrode provided on the passivation layer, and the conductive surface being a surface of the first electrode facing away from the base substrate; an organic light emitting layer provided within the hollow portion; and a second electrode covering the organic light emitting layer and the pixel defining layer.

According to embodiments of the disclosure, a display substrate is provided. The display substrate comprises: a base substrate; and a pixel defining layer having a hollow portion and located above the base substrate. The hollow portion is enclosed by sidewalls of the pixel defining layer, and exposes a portion of a conductive surface at a bottom of the hollow portion; in a cross-sectional view of the display substrate, the sidewalls include two side edges respectively located on two opposite sides of the hollow structure, each of the side edges is an arc-shaped line segment, the arc-shaped line segment has a first end point that meets the conductive surface and a second end point that meets a surface of the pixel defining layer facing away from the base substrate, a second included angle between a virtual straight line connecting the first end point and the second end point and the conductive surface is greater than 20°, and a third included angle between a tangent line at any point on the arc-shaped line segment and the conductive surface is less than 35°.

According to the embodiments of the disclosure, the second included angle is greater than 23°, and the third included angle is less than 30°.

According to the embodiments of the disclosure, the virtual straight connection line is located inside the hollow portion; or, the virtual straight connection line is located outside the hollow portion.

According to the embodiments of the disclosure, the display substrate has a light emitting region, and an orthogonal projection of the portion of the conductive surface exposed by the hollow portion of the pixel defining layer on the base substrate completely coincides with an orthogonal projection of the light emitting region on the base substrate.

According to the embodiments of the disclosure, the pixel defining layer has a thickness of 1.0 µm to 3.0 µm.

According to the embodiments of the disclosure, the display substrate further comprises: a driving unit provided on the base substrate; a passivation layer covering the driving unit; a first electrode provided on the passivation layer, and the conductive surface being a surface of the first electrode facing away from the base substrate; an organic light emitting layer provided within the hollow portion; and a second electrode covering the organic light emitting layer and the pixel defining layer.

According to the embodiments of the disclosure, a display device is provided. The display device comprises any one of the display substrates as described above.

### BRIEF DESCRIPTION OF THE DRAWINGS

In order to more clearly illustrate the technical solutions of the embodiments of the present disclosure, the drawings used in the description of the embodiments will be briefly described below. It is obvious that the drawings in the following description are only some embodiments of the present disclosure, those skilled in the art can obtain other drawings based on these drawings without any inventive work.
FIG. 1 is a cross-sectional structural schematic diagram of an AMOLED display;
FIG. 2 is a cross-sectional structural schematic diagram of a display substrate provided by embodiments of the present disclosure;
FIG. 3 is a cross-sectional structural schematic diagram of the display substrate provided by the embodiments of the present disclosure;
FIG. 4 is a cross-sectional structural schematic diagram of the display substrate provided by the embodiments of the present disclosure;
FIG. 5 is a cross-sectional structural schematic diagram of the display substrate provided by the embodiments of the present disclosure;
FIG. 6 is a cross-sectional structural schematic diagram of the display substrate provided by the embodiments of the present disclosure;
FIG. 7 is a cross-sectional structural schematic diagram of the display substrate provided by the embodiments of the present disclosure;
FIG. 8 is a cross-sectional structural schematic diagram of the display substrate provided by the embodiments of the present disclosure; and
FIG. 9 is a schematic diagram of a display device provided by the embodiments of the present disclosure.

### DETAILED DESCRIPTION

Hereinafter, the technical solutions in the embodiments of the present disclosure will be described in a clearly and fully understandable way in connection with the drawings related to the embodiments of the present disclosure. It is obvious that the described embodiments are just a part but not all of the embodiments of the present disclosure. Based on the described embodiments herein, those skilled in the art can obtain other embodiment(s), without any inventive work, which should be within the scope of the present disclosure.

It should be noted that, unless otherwise defined, all terms used herein (including technical and scientific terms) have a same meaning as commonly understood by those skilled in the art to which the present disclosure pertains. It will be further understood that terms, such as those defined in commonly used dictionaries, should be interpreted as having a meaning that is consistent with their meaning in the context of the relevant art and will not be interpreted in an ideal or excessively formal sense unless clearly defined in the present specification.

For example, in the specification and claims of the present disclosure, words such as "first", "second" and the like do not denote any order, quantity, or importance, but rather are used for distinguishing different components. Words such as "include" or "comprise" and the like denote that elements or objects appearing before the words of "include" or "comprise" cover the elements or the objects enumerated after the words of "include" or "comprise" or equivalents thereof, not exclusive of other elements or objects. Directional or positional relationships shown by terms such as "upper/above", "lower/below" are directional or positional relationships shown as in the drawings, which only means to facilitate description of the technical solution or the present disclosure and simplify the description, but do not indicate or imply that the devices or components must have specific directions, or be constructed or operated in the specific directions, and are not limitative of the present disclosure.

Embodiments of the present disclosure provide a display substrate and a display device; in a case where an organic light emitting layer is deposited within a hollow portion of a pixel defining layer, a specific angle of a side edge of the pixel defining layer is designed to weaken an extent to which the organic light emitting layer slides and is accumulated by gravity at corners of the hollow portion, so as to improve evenness of a thickness of the organic light emitting layer, and further improve a display quality of the display substrate.

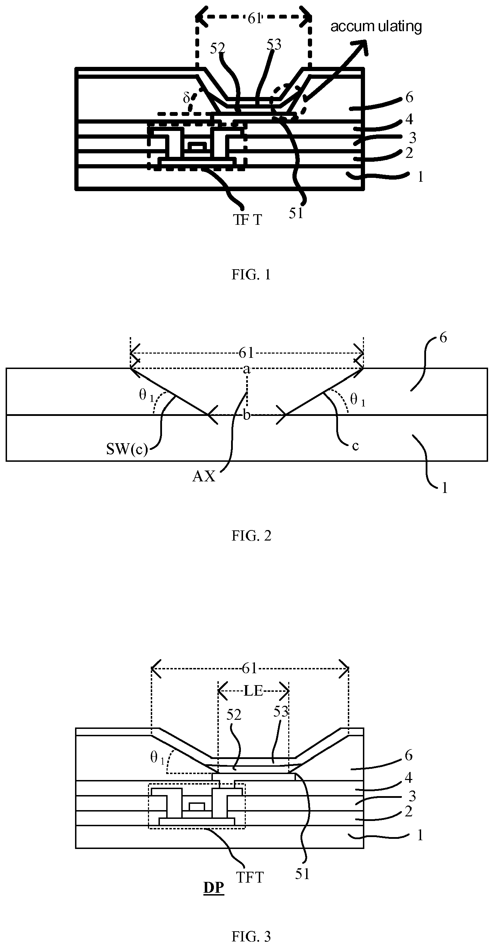

As shown in FIG. 1, it is a structural schematic diagram of an AMOLED display. A thin film transistor (TFT, denoted as TFT in the diagram) for driving an OLED element is formed on a base substrate 1; a gate insulating layer 2 for isolating a gate electrode of the TFT from a semiconductor layer of the TFT, and an interlayer insulating layer 3 for isolating the gate electrode from a source electrode and a drain electrode of the TFT are further formed on the base substrate 1. A passivation layer 4 for covering the TFT is formed on the TFT. A via hole that exposes the drain electrode of the TFT is formed in the passivation layer 4. An anode 51 of the OLED element is formed on the passivation layer 4 and is in electrical connection with the drain electrode through the above-described via hole. A pixel defining layer 6 is located on the passivation layer 4 and the anode 51, and a hollow portion 61 (i.e., an opening) of the pixel defining layer 6 exposes a portion of the anode 51. An organic light emitting layer 52 of the OLED element is deposited on the anode 51, and a cathode 53 of the OLED element covers the organic light emitting layer 52 and the pixel defining layer 6.

The organic light emitting layer 52 is usually deposited within the hollow portion 61 of the pixel defining layer 6 in a mode of evaporation, spin coating or ink jet printing; in this case, with reference to FIG. 1, an included angle (denoted as δ in the diagram) between a side edge of the pixel defining layer 6 and a surface of the substrate is relatively large, that is, a slope of the hollow portion 61 of the pixel defining layer 6 is relatively steep, thus the organic light emitting layer 52, subjected to a gravity action, is apt to accumulate at corners of the hollow portion 61 during deposition (as shown by a portion circled by a dotted line in the diagram), so that a thickness of a portion of the organic light emitting layer 52 at a boundary between the pixel defining layer 6 and the anode 51 is larger than a thickness of a portion of the organic light emitting layer 52 at a central region of the anode 51, resulting in brighter luminescence in the central region and darker luminescence at the boundary between the pixel defining layer 6 and the anode 51, causing uneven brightness of the OLED element, and affecting the display quality.

As shown in FIG. 2, the embodiments of the present disclosure provide a display substrate, comprising a base substrate 1, and a pixel defining layer 6 provided above the base substrate 1; the pixel defining layer 6 including a plurality of hollow portions 61 (only one is shown in the diagram) spaced from each other; and along a direction perpendicular to the base substrate 1, a cross-sectional view of the hollow portion 61 including: a first edge a and a second edge b parallel to the base substrate 1 and opposite to each other, two side edges c respectively connecting the first edge a and the second edge b. The first edge a is larger than the second edge b, and the second edge b is between the base substrate 1 and the first edge a; and an included angle between the side edge c and an extension line of the second edge b is a first included angle (denoted as θ1 in the diagram), and the first included angle θ1 is greater than 20° and less than 35°. Here, the first edge a and the second edge b are both virtual edges instead of actually existing edges.

The pixel defining layer 6 is located above the base substrate 1, and other structural layers may be further provided therebetween.

In a case where the above-described first included angle θ1 is less than 35°, a sliding effect of an organic light emitting layer by gravity is relatively small, so that the organic light emitting layer deposited within the hollow portion 61 has an even thickness. It is considered that, with respect to the pixel defining layer 6 having a certain area, in a case where the number of hollow portions 61 is determined, the smaller the angle of the side edge c of the hollow portion 61 is, the smaller the effective light-emitting area of the hollow portion 61 (i.e., corresponding to a pixel region of the display substrate) is; and thus, in consideration of a requirement on the pixel light-emitting area after the pixel defining layer 6 is applied to the display substrate, the above-described first included angle θ1 is greater than 20° while being less than 35°.

The above-described first included angle θ1 is further greater than 23° and less than 30°.

Under the premise that the first included angle θ1 between the side edge c and the extension line of the second edge b is greater than 20° and less than 35°, with respect to any one of the hollow portions 61 which is a stereoscopic region, there are a plurality of cross-sectional views thereof along the direction perpendicular to the base substrate 1, the first included angles θ1, each of which is between the side edge c and the extension line of the second edge b, in the cross-sectional views of any one of the hollow portions 61 are the same or different. In consideration of simplification of process, the first included angles θ1, each of which is between the side edge c and the extension line of the second edge b, in the cross-sectional views of any one hollow portion 61 are set to a same value. For example, the hollow portion 61 is symmetrical about a symmetry axis AX. The symmetry axis AX is perpendicular to the base substrate 1.

With respect to different hollow portions 61 within a same cross section, the first included angles θ1, each of which is between the side edge c and the extension line of the second edge b, in the cross-sectional views of the hollow portions 61 are the same or different. In consideration of simplification of process, the first included angles θ1, each of which is between the side edge c and the extension line of the second edge b, in the cross-sectional views of the hollow portions 61 are set to a same value. Further, on the above-described basis, as shown in FIG. 3, there are a plurality of light emitting regions LE (only one is shown in FIG. 3) comprised in the above-described display substrate. The hollow portions 61 of the pixel defining layer 6 shown in FIG. 2 are in one-to-one correspondence with the light emitting regions LE.

The above-described display substrate is, for example, an array substrate; and with reference to FIG. 3, the above-described display substrate further comprises: a driving unit (denoted as TFT in the diagram) provided on the base substrate 1; a passivation layer 4 covering the driving unit TFT. A gate electrode of the TFT is isolated by a gate insulating layer 2 from a semiconductor layer of the TFT, and the gate electrode of the TFT is isolated by an interlayer insulating layer 3 from a source electrode and a drain electrode of the TFT. The above-described display substrate for example further comprises a planarization layer (not shown) provided on the passivation layer 4. The above-described display substrate for example further comprises: a plurality of anodes 51 spaced from each other and provided on the passivation layer 4, the hollow portion 61 of the above-described pixel defining layer 6 corresponding to a portion of the anode 51; an organic light emitting layer 52 provided within the hollow portion 61; and a cathode 53 covering the organic light emitting layer 52 and the pixel defining layer 6.

Here, since the first edge a is larger than the second edge b and the second edge b is located between the base substrate 1 and the first edge a, the first edge a is necessarily an upper edge in the cross-sectional view of the hollow portion 61 facing away from the base substrate 1, and the opposite second edge b is necessarily a lower edge in the cross-sectional view of the hollow portion 61 close to the base substrate 1, that is, the cross-sectional view of the hollow portion 61 is an inverted trapezoid.

In consideration of a fact that the organic light emitting layer 52 to be deposited needs to have a certain thickness, a thickness of the pixel defining layer 6 is, for example, 1.0 µm to 3.0 µm, so as to provide a deposition space with a certain depth for the organic light emitting layer 52.

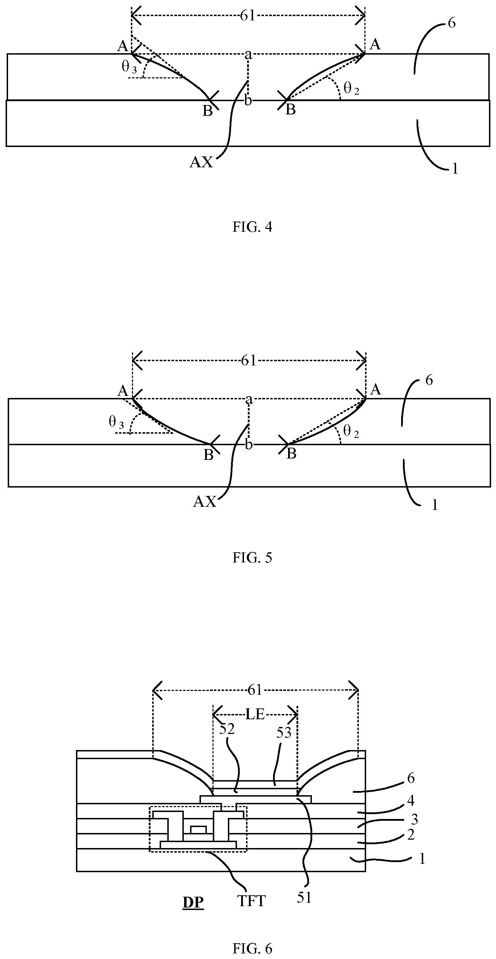

As shown in FIG. 4 or FIG. 5, the embodiments of the present disclosure provides the display substrate, comprising the base substrate 1, and the pixel defining layer 6 provided above the base substrate 1; the pixel defining layer 6 including the plurality of hollow portions 61 (only one is shown in the diagram) spaced from each other; and along the direction perpendicular to the base substrate 1, the cross-sectional view of the hollow portion 61 including: a first edge a and a second edge b parallel to the base substrate 1 and opposite to each other, and two minor arc-shaped side edges c respectively connecting the first edge a and the second edge b. The first edge a is larger than the second edge b, and the second edge b is located between the base substrate 1 and the first edge a; the side edge c includes a first end point (denoted as A in the diagram) connected with the first edge a, and a second end point (denoted as B in the diagram) connected with the second edge b; an included angle between a line connecting the first end point A and the second end point B and the extension line of the second edge b is a second included angle (denoted as θ2 in the diagram), and the second included angle θ2 is greater than 20°; and an included angle between a tangent line at any point on the side edge c and the extension line of the second edge b is a third included angle θ3 (denoted as θ3 in the diagram), and the third included angle θ3 is less than 35°. Here, both the first edge a and the second edge b are virtual edges instead of actually existing edges.

It should be noted that, the pixel defining layer 6 is located above the base substrate 1, and other structural layers may be further provided therebetween.

The pixel defining layer 6 for example is made of a photoresist resin material, in a case where the hollow portion 61 of the pixel defining layer 6 is formed in a mode of exposure and development, the side edge of the pixel defining layer 6 is not a perfect straight line but a curved minor arc (i.e., a center angle corresponding to the arc is less than 180°). The second included angle θ2 between the connection line of the two end points and the extension line of the second edge b is greater than 20°, and the third included angle θ3 between the tangent line at any point on the minor arc and the extension line of the second edge b is less than 35°, so the sliding effect of the organic light emitting layer at the side edge of the hollow portion 61 by gravity is relatively small, so that the organic light emitting layer deposited within the hollow portion 61 has an even thickness.

The above-described second included angle θ2 is further greater than 23°, and the above-described third included angle θ3 is further less than 30°.

Under the premise that the second included angle θ2 between the connection line of the two end points and the extension line of the second edge b is greater than 20° and the third included angle θ3 between the tangent line at any point on the minor arc and the extension line of the second edge b is less than 35°, with respect to any one of the hollow portions 61 which is the stereoscopic region, there are the plurality of cross-sectional views thereof along the direction perpendicular to the base substrate 1, the second included angles θ2, each of which is between the connection line of two end points of the side edge c and the extension line of the second edge b, in the cross-sectional views of any one of the hollow portions 61 are the same or different, and the third included angles θ3, each of which is between the tangent line at any point on the side edge c and the extension line of the second edge b, in the cross-sectional views of any one of the hollow portions 61 are the same or different. In consideration of simplification of process, the second included angles θ2, each of which is between the connection line of two end points of the side edge c and the extension line of the second edge b, in the cross-sectional views of any one of the hollow portions 61 are set to a same value, and the third included angles θ3, each of which is between the tangent line at any point on the side edge c and the extension line of the second edge b, in the cross-sectional views of any one of the hollow portions 61 are set to a same value.

With respect to different hollow portions 61 within the same cross section, the second included angles θ2, each of which is between the connection line of two end points of the side edge c and the extension line of the second edge b, in the cross-sectional views of the hollow portions 61 are the same or different, and the third included angles θ3, each of which is between the tangent line at any point on the side edge c and the extension line of the second edge b, in the cross-sectional views of the hollow portions 61 are the same or different. In consideration of simplification of process, the second included angles θ2, each of which is between the connection line of two end points of the side edge c and the extension line of the second edge b, in the cross-sectional views of the hollow portions 61 are set to a same value, and the third included angles θ3, each of which is between the tangent line at any point on the side edge c and the extension line of the second edge b, in the cross-sectional views of the hollow portions 61 are set to a same value. For example, the hollow portion 61 is symmetrical about the symmetry axis AX. The symmetry axis AX is perpendicular to the base substrate 1.

With reference to FIG. 4, the side edge c is recessed toward a region where the first edge a and the second edge b are opposite to each other, that is, is recessed inward with respect to the hollow portion 61, and the connection line of the two end points of the minor arc is located outside the hollow portion 61.

For example, with reference to FIG. 5, the side edge c protrudes from the region where the first edge a and the second edge b are opposite to each other, that is, protrudes outward with respect to the hollow portion 61, and the connection line of the two end points of the minor arc is located inside the hollow portion 61.

Here, the connection line of the two end points of the minor arc is a virtual straight line.

Further, on the above-described basis, as shown in FIG. 6, there are the plurality of light emitting regions LE (only one is shown in FIG. 6) comprised in the above-described display substrate. The hollow portions 61 of the pixel defining layer 6 shown in FIG. 4 or FIG. 5 are in one-to-one correspondence with the light emitting regions LE.

The above-described display substrate for example is the array substrate; and with reference to FIG. 6, the display substrate comprises: the driving unit (denoted as TFT in the diagram) provided on the base substrate 1; and the passivation layer 4 covering the driving unit TFT. The gate electrode of the TFT is isolated by the gate insulating layer 2 from the semiconductor layer of the TFT, and the gate electrode of the TFT is isolated by the interlayer insulating layer 3 from the source electrode and the drain electrode of the TFT. The above-described display substrate for example further comprises the planarization layer (not shown) provided on the passivation layer 4. The above-described display substrate for example further comprises: the plurality of anodes 51 spaced from each other and provided on the passivation layer 4, the hollow portion 61 of the above-described pixel defining layer 6 corresponding to a portion of the anode 51; the organic light emitting layer 52 provided within the hollow portion 61; and the cathode 53 covering the organic light emitting layer 52 and the pixel defining layer 6.

Here, description is provided in the above-described FIG. 6 merely with the pixel defining layer 6 recessed inward with respect to the hollow portion 61 as illustrated in the foregoing FIG. 4 as an example, which is equally applicable to the pixel defining layer 6 protruding outward with respect to the hollow portion 61 as illustrated in FIG. 5, and will not be repeated here. Here, since the first edge a is larger than the second edge b, and the second edge b is located between the base substrate 1 and the first edge a, the first edge a is necessarily the upper edge in the cross-sectional view of the hollow portion 61 facing away from the base substrate 1, and the opposite second edge b is necessarily the lower edge in the cross-sectional view of the hollow portion 61 close to the base substrate 1, that is, the cross-sectional view of the hollow portion 61 is an inverted trapezoid whose side edges are recessed minor arcs or protruding minor arcs.

For example, in consideration of the fact that the organic light emitting layer 52 to be deposited needs to have a certain thickness, the thickness of the pixel defining layer 6 is, for example, 1.0 µm to 3.0 µm, so as to provide the deposition space with a certain depth for the organic light emitting layer 52.

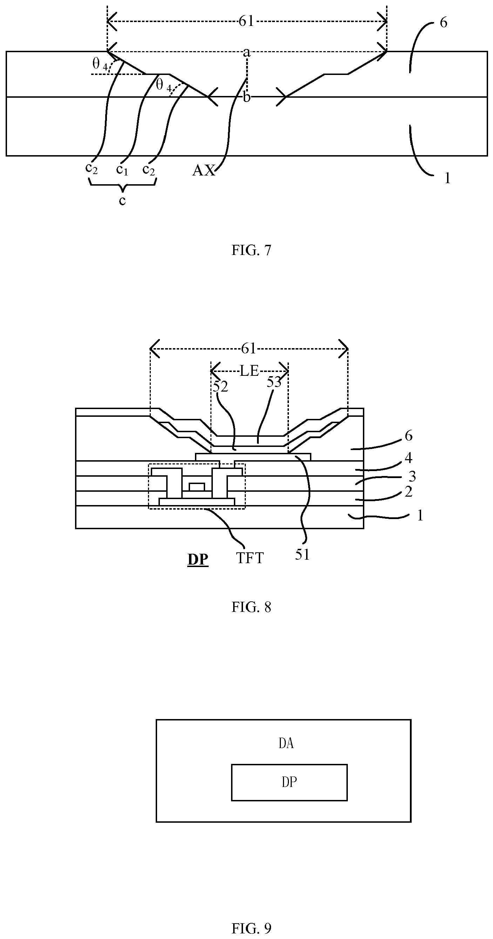

As shown in FIG. 7, the embodiments of the present disclosure provide the display substrate, comprising the base substrate 1, and the pixel defining layer 6 provided above the base substrate 1; the pixel defining layer 6 including the plurality of hollow portions 61 (only one is shown in the diagram) spaced from each other and at least one step provided inside the hollow portion 61; along the direction perpendicular to the base substrate 1, the cross-sectional view of the hollow portion 61 including: the first edge a and the second edge b provided parallel to the base substrate 1 and opposite to each other, two polyline-shaped side edges c respectively connecting the first edge a and the second edge b. The first edge a is larger than the second edge b, and the second edge b is located between the base substrate 1 and the first edge a; the side edge c includes at least one first line segment c1 parallel to the base substrate 1 and at least two second line segments c2; and included angles respectively between the second line segments c2 and the extension line of the second edge b are fourth included angles (denoted as θ4 in the diagram), each of the fourth included angles θ4 is greater than 20° and less than 35°. Here, the first edge a and the second edge b are both virtual edges instead of actually existing edges.

The pixel defining layer 6 is located above the base substrate 1, and other structural layers may be further provided therebetween.

With reference to FIG. 7, description is provided in the embodiments of the present disclosure merely with a case where the number of steps inside the above-described hollow portion 61 is one as an example, that is, in the cross-sectional view of the hollow portion 61, the side edge c includes one first line segment c1 parallel to the layer plane (i.e., a cross section of the step presented as a line segment) and two second line segments c2; the number of steps will not be limited in the embodiments of the present disclosure, and the specific number of steps may be flexibly designed according to a size of the hollow portion 61 and a weakening effect on the sliding of the organic light emitting layer.

In a case where the organic light emitting layer of the OLED element is formed within the hollow portion 61 of the above-described pixel defining layer 6, the organic light emitting layer has a portion provided on the step, and the step protruding toward the inside of the hollow portion 61 weakens an extent to which the organic light emitting layer slides and is accumulated by gravity, so that the portion of the organic light emitting layer at the boundary of the anode and the pixel defining layer 6 and the portion of the organic light emitting layer at the central region of the anode have even thicknesses, which further improves the display quality.

In a case the fourth included angle θ4 is less than 35°, the sliding effect of the organic light emitting layer caused by gravity is relatively small, so that the organic light emitting layer deposited within the hollow portion 61 has an even thickness. It is considered that, with respect to the pixel defining layer 6 having a certain area, in a case where the number of hollow portions 61 is determined, the smaller the inclined angle of the second line segment c2 of the side edge c of the hollow portion 61 is, the smaller the effective light-emitting area of the hollow portion 61 (i.e., corresponding to the pixel region of the display substrate) is; and thus, in consideration of the requirement on the pixel light-emitting area after the pixel defining layer 6 is applied to the display substrate, the above-described fourth included angle θ4 is greater than 20° while being less than 35°. The above-described fourth included angle θ4 is further greater than 23° and less than 30°.

Under the premise that the fourth included angle θ4 between the second line segment c2 and the extension line of the second edge b is greater than 20° and less than 35°, with respect to any one of the hollow portions 61, the fourth included angles θ4 respectively between the second line segments c2 of each side edge c and the extension line of the second edge b are the same or different. In consideration of simplification of process, the fourth included angle θ4 respectively between the second line segments c2 of each side edge c and the extension line of the second edge b of any one hollow portion 61 are set to a same value, that is, the second line segments c2 of a same side edge c are parallel to one another.

With respect to any one of the hollow portions 61 which is the stereoscopic region, there are a plurality of cross-sectional views thereof along the direction perpendicular to the base substrate 1, the fourth included angles θ4, each of which is between the second line segment c2 of the side edge c and the extension line of the second edge b, in the cross-sectional views of any one of the hollow portions 61 are the same or different. In consideration of simplification of process, the fourth included angles θ4, each of which is between the second line segment c2 of the side edge c and the extension line of the second edge b, in the cross-sectional views of any one of hollow portions 61 are set to a same value.

With respect to different hollow portions 61 within the same cross section, the fourth included angles θ4, each of which is between the second line segment c2 of the side edge c and the extension line of the second edge b, in the cross-sectional views of the hollow portions 61 are the same or different. In consideration of simplification of process, the fourth included angles θ4, each of which is between the second line segment c2 of the side edge c and the extension line of the second edge b, in the cross-sectional views of the hollow portions 61 are set to a same value. For example, the hollow portion 61 is symmetrical about the symmetry axis AX. The symmetry axis AX is perpendicular to the base substrate 1.

Further, on the above-described basis, as shown in FIG. 8, there are the plurality of light emitting regions LE (only one is shown in FIG. 8) comprised in the above-described display substrate. The hollow portions 61 of the pixel defining layer 6 shown in FIG. 7 are in one-to-one correspondence with the light emitting regions LE.

The above-described display substrate for example is the array substrate; and with reference to FIG. 8, the display substrate comprises: the driving unit (denoted as TFT in the diagram) provided on the base substrate 1; and the passivation layer 4 covering the driving unit TFT. The gate electrode of the TFT is isolated by the gate insulating layer 2 from the semiconductor layer of the TFT, and the gate electrode of the TFT is isolated by the interlayer insulating layer 3 from the source electrode and the drain electrode of the TFT. The above-described display substrate for example further comprises the planarization layer (not shown) provided on the passivation layer 4. The above-described display substrate for example further comprises: the plurality of anodes 51 spaced from each other and provided on the passivation layer 4, the hollow portion 61 of the above-described pixel defining layer 6 corresponding to a portion of the anode 51; the organic light emitting layer 52 provided within the hollow portion 61; and the cathode 53 covering the organic light emitting layer 52 and the pixel defining layer 6.

The organic light emitting layer 52 has a portion located on the step inside the hollow portion 61, and the step weakens an extent to which the organic light emitting layer 52 slides and is accumulated by gravity, so that the portion of the organic light emitting layer 52 at the boundary of the anode 51 and the pixel defining layer 6 and the portion of the organic light emitting layer 52 at the central region of the anode 51 have even thicknesses, which further improves the display quality.

Here, since the first edge a is larger than the second edge b, the step is located inside the hollow portion 61 and the second edge b is located between the base substrate 1 and the first edge a, the first edge a is necessarily the upper edge in the cross-sectional view of the hollow portion 61 facing away from the base substrate 1, and the opposite second edge b is necessarily the lower edge in the cross-sectional view of the hollow portion 61 close to the base substrate 1, that is, the cross-sectional view of the hollow portion 61 is an inverted trapezoid whose side edges have steps.

For example, in consideration of the fact that the organic light emitting layer 52 to be deposited needs to have a certain thickness, the thickness of the pixel defining layer 6 is, for example, 1.0 µm to 3.0 µm, so as to provide the deposition space with a certain depth for the organic light emitting layer 52.

In the above-described respective embodiments, the above-described display substrate further comprises a gate line and a gate line lead wire provided in a same layer as the gate electrode of the TFT; and a data line and a data line lead wire provided in a same layer as the source electrode and the drain electrode of the TFT. A pattern layer including the gate line, the gate electrode of the TFT and the gate line lead wire, and a pattern layer including the data line, the source electrode and the drain electrode of the TFT, and the data line lead wire for example are made of copper (Cu), aluminum (Al), molybdenum (Mo), titanium (Ti), chromium (Cr), tungsten (W), or other metal element materials, or an alloy of these materials. A specific structure of the above-described respective pattern layers for example is a single-layer structure, or a multilayer structure, for example, Mo\Al\Mo, Ti\Cu\Ti, Mo\Ti\Cu, or other stacked structures as designed.

The TFT for example is an amorphous silicon TFT, a poly-silicon TFT, or an oxide semiconductor TFT; and a structure thereof for example is a top gate type or a bottom gate type.

For example, in some TFT structures, the gate electrode is a portion of the gate line (i.e., there is no independent gate electrode pattern branching from the gate line); the source electrode is a portion of the data line (i.e., there is no independent source electrode pattern branching from the data line); and a specific structure of the TFT will not be limited in the embodiments of the present disclosure, which may follow various TFT structures in the prior art, or a type and/or a structure of the TFT is flexibly selected according to a specific structural requirement on the above-described display substrate.

The gate insulating layer 2 for example is made of silicon nitride or silicon oxide, and a specific structure thereof for example is a single-layer structure, or a multilayer structure, for example, silicon oxide/silicon nitride stacked as designed.

The passivation layer 4 covering the TFT for example is made of silicon nitride or silicon oxide, and a structure thereof for example is a single-layer structure, or a multilayer structure, for example, silicon oxide/silicon nitride stacked as designed.

The planarization layer (not shown in the above-described accompanying drawings) for example is made of a resin material.

The anode 51 for example is made of indium tin oxide (ITO), indium zinc oxide (IZO), fluorine-doped tin oxide (FTO) or other transparent metal oxide conductive materials, or a multilayer stacked structure of the above-described transparent metal oxide conductive material and a metal material (for example, silver (Ag)), for example, it is prepared with three layers of ITO\Ag\ITO.

The cathode 53 for example is made of aluminum (Al) and/or silver (Ag), or other metal materials, and a structure thereof for example is a single-layer structure or a multilayer stacked structure.

In the above-described embodiments, the hollow portion 61 is formed to be enclosed by sidewalls SW of the pixel defining layer 6 and exposes a portion of an upper surface of the anode 51 at the bottom thereof. For example, the upper surface of the anode 51 is parallel to an upper surface of the base substrate.

On the above-described basis, the embodiments of the present disclosure further provide a display device DA, comprising the display substrate DP according to the above-described respective embodiments. The above-described display device for example is an OLED display device, such as an OLED display, an OLED television, a digital photo frame, a mobile phone, a tablet personal computer, a navigator, or any other product or component having a display function.

The above are only specific embodiments of the present disclosure, but the scope of the embodiment of the present disclosure is not limited thereto, and any skilled in the art, within the technical scope disclosed by the present disclosure, can easily think of variations or replacements, which should be covered within the protection scope of the present disclosure. Therefore, the scope of the present disclosure should be the scope of the following claims.

The foregoing embodiments merely are exemplary embodiments of the present disclosure, and not intended to define the scope of the present disclosure, and the scope of the present disclosure is determined by the appended claims.

## Claims

1. A display substrate comprising:
a base substrate; and
a pixel defining layer having a hollow portion and located above the base substrate, wherein,
the hollow portion is enclosed by sidewalls of the pixel defining layer, and exposes a portion of a conductive surface at a bottom of the hollow portion;
in a cross-sectional view of the display substrate, the sidewalls are respectively indicated by two side edges located on two opposite sides of the hollow portion, each of the side edges at least includes a first straight line segment in direct contact with the conductive surface, and a first included angle between the first straight line segment and the conductive surface is greater than 20° and less than 35°.

2. The display substrate according to claim 1, wherein, the first included angle is further greater than 23° and less than 30°.

3. The display substrate according to claim 1 or 2, wherein, the hollow portion is symmetrical about a symmetry axis.

4. The display substrate according to any one of claims 1 to 3, wherein, in the cross-sectional view of the display substrate, the first straight line segment meets a surface of the pixel defining layer facing away from the base substrate.

5. The display substrate according to any one of claims 1 to 3, wherein, in the cross-sectional view of the display substrate, each of the side edges further includes a second straight line segment that meets a surface of the pixel defining layer facing away from the base substrate and a third straight line segment connecting the first straight line segment and the second straight line segment.

6. The display substrate according to claim 5, wherein, the second straight line segment is parallel to the first straight line segment, and the third straight line segment is parallel to the conductive surface.

7. The display substrate according to any one of claims 1 to 6, wherein, the display substrate has a light emitting region, and an orthogonal projection of the portion of the conductive surface exposed by the hollow portion of the pixel defining layer on the base substrate completely coincides with an orthogonal projection of the light emitting region on the base substrate.

8. The display substrate according to any one of claims 1 to 7, wherein, the pixel defining layer has a thickness of 1.0 µm to 3.0 µm.

9. The display substrate according to any one of claims 1 to 8, further comprising:
a driving unit provided on the base substrate;
a passivation layer covering the driving unit;
a first electrode provided on the passivation layer, and the conductive surface being a surface of the first electrode facing away from the base substrate;
an organic light emitting layer provided within the hollow portion; and
a second electrode covering the organic light emitting layer and the pixel defining layer.

10. A display substrate, comprising:
a base substrate; and
a pixel defining layer having a hollow portion and located above the base substrate, wherein,
the hollow portion is enclosed by sidewalls of the pixel defining layer, and exposes a portion of a conductive surface at a bottom of the hollow portion;
in a cross-sectional view of the display substrate, the sidewalls include two side edges respectively located on two opposite sides of the hollow portion, each of the side edges is an arc-shaped line segment, the arc-shaped line segment has a first end point that meets the conductive surface and a second end point that meets a surface of the pixel defining layer facing away from the base substrate, a second included angle between a virtual straight line connecting the first end point and the second end point and the conductive surface is greater than 20°, and a third included angle between a tangent line at any point on the arc-shaped line segment and the conductive surface is less than 35°.

11. The display substrate according to claim 10, wherein, the second included angle is greater than 23°, and the third included angle is less than 30°.

12. The display substrate according to claim 10 or 11, wherein,
the virtual straight connection line is located inside the hollow portion; or, the virtual straight connection line is located outside the hollow portion.

13. The display substrate according to any one of claims 10 to 12, wherein, the display substrate has a light emitting region, and an orthogonal projection of the portion of the conductive surface exposed by the hollow portion of the pixel defining layer on the base substrate completely coincides with an orthogonal projection of the light emitting region on the base substrate.

14. The display substrate according to any one of claims 10 to 13, wherein, the pixel defining layer has a thickness of 1.0 µm to 3.0 µm.

15. The display substrate according to any one of claims 10 to 14, further comprising:
a driving unit provided on the base substrate;
a passivation layer covering the driving unit;
a first electrode provided on the passivation layer, and the conductive surface being a surface of the first electrode facing away from the base substrate;
an organic light emitting layer provided within the hollow portion; and
a second electrode covering the organic light emitting layer and the pixel defining layer.

16. A display device, comprising the display substrate according to any one of claims 1 to 15.
